# EUROPEAN PATENT APPLICATION

(11) **EP 2 348 633 A1**
(43) Date of publication of application: **27.07.2011**
(21) Application number: 11151680.3
(22) Date of filing: 21.01.2011
(51) Int. Cl.: H03H 9/02

(54) **Temperature compensation device and method for MEMS resonator**

(30) Priority: 21.01.2010 US 297009 P
(71) Applicant: IMEC, 3001 Leuven (BE)
(72) Inventor: Stoffels, Steve, 3530 Houthalen (BE); Tilmans, Hendrikus, 3630 Maasmechelen (BE)
(74) Representative: Sarlet, Steven Renaat Irène

(57) **Abstract**

The invention relates to a device comprising a MEM resonating element (20), provided for resonating at a predetermined resonance frequency and having at least one temperature dependent characteristic, a heating means (40), comprising a tunable thermal radiation source (40) for heating the MEM resonating element to an offset temperature (T_{offset}), a sensing means (11, 12), associated with the MEM resonating element and provided for sensing its temperature dependent characteristic, and a control circuit (30), connected to the sensing means (11, 12) for receiving measurement signals indicative of the sensed temperature dependent characteristic and connected to the heating means (40) for supplying a control signal (31) thereto, to maintain the temperature of the MEM resonating element (20) at the offset temperature.

## Description

### Technical field

The present invention relates to a device and a method for compensating the temperature in a MEM resonator.

### Background art

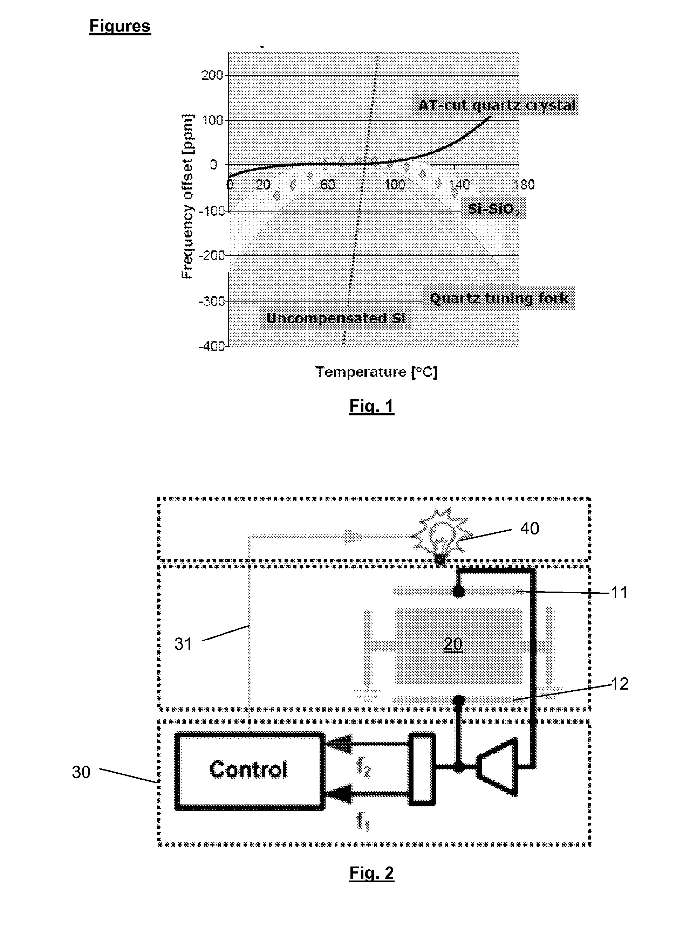

Micro-electromechanical (MEM) resonators can be used as accurate timing references, to replace for example quartz crystals in timing circuits as disclosed by W.-T., Hsu, J. R. Clark, et al., in "Mechanically temperature-compensated flexural-mode micromechanical resonators", Technical Digest International Electron Devices Meeting 2000 (IEDM2000), pp. 399-402, hereby incorporated by reference in its entirety. One of the drawbacks of these MEMS resonators is the resonant frequency drift with respect to temperature and aging. Typical values for frequency drift with respect to temperature are several tens to hundreds of ppm/°C, depending on the structural material(s) constituting the MEMS resonator, e.g. Si, Si-Si02. Quartz crystals on the other hand have a temperature stability of 1 ppm/°C or lower (see figure 1: quartz crystal (AT-cut, tuning fork), Si-MEMS crystal, Si-Si02 MEMS crystal). For MEMS resonators to become a viable alternative to quartz crystals, they will have to reach comparable temperature stabilities.

Temperature compensation of the resonance frequency, i.e. the control of thermally induced frequency variations, is mostly achieved using electrical techniques, in which a controlled voltage or current provides frequency tuning. These techniques are also used in the following background documents.

Several solutions addressing the issue of temperature compensation are known. US 6987432 discloses active and passive solutions. An active solution comprises determining the actual operating frequency for a beam resonator in relation to a desired resonance frequency, and thereafter applying a compensating stiffness to the resonator to maintain the desired resonance frequency. Passive solutions for frequency stabilization with temperature of a MEMS resonator which are disclosed result from specific steps during the method of fabricating a micromechanical resonator, so that the working gap between the beam and the electrode adjusts itself with temperature to vary a compensating stiffness applied to the beam.

US 7427905 discloses a temperature controlled MEMS resonator and a method for controlling resonator frequency by providing an electrical current to the beam structure and thereby heating the beam structure.

### Disclosure of the invention

It is an aim of the present invention to provide an alternative temperature stabilized MEM resonator and an alternative method for temperature stabilizing a MEM resonator.

This aim is achieved according to the invention as defined in the independent claims.

As used herein, with "offset temperature" is intended a temperature substantially above ambient temperature, such that an element heated to the offset temperature by means of a heat source can be cooled by switching off or reducing the heat source.

As used herein, with "MEM resonating element" is intended a micro-electromechanical element which is arranged for resonating at a predetermined resonance frequency (or in multiple modes) in response to any given source of energy causing its resonation, such as for example a beam suspended above a substrate by means of tethers between a pair of electrodes by means of which a suitable bias can be applied.

As used herein, with "temperature dependent characteristic" of the MEM resonating element is intended that the MEM resonating element has at least one physical, mechanical or electrical parameter having a thermal coefficient and whose value is hence dependent on the operating temperature of the MEM element. This parameter can be: the resonance frequency, the resistance, the thermal radiation, or any other temperature dependent parameter known to the person skilled in the art.

The invention provides a device comprising: a MEM resonating element, provided for resonating at a predetermined resonance frequency, the MEM resonating element having a temperature dependent characteristic; a heating means, arranged for heating the MEM resonating element to an offset temperature (T_{offset}); a sensing means, associated with the MEM resonating element and provided for sensing its temperature dependent characteristic; a control circuit, connected to the sensing means for receiving measurement signals indicative of the sensed temperature dependent characteristic and connected to the heating means for supplying a control signal thereto, to maintain the temperature of the MEM resonating element at the offset temperature. According to the invention, the heating means comprises a tunable thermal radiation source and the MEM resonating element is provided for absorbing thermal radiation generated by the tunable thermal radiation source.

In other words, the MEM resonating element is arranged for receiving thermal radiation emitted by the tunable thermal radiation source while the control circuit is arranged for monitoring a variation in at least one temperature dependent parameter of the MEM resonating element. Upon absorbing this thermal energy the resonator is heated and the value of the at least one temperature dependent parameter changes. A shift in this parameter value is monitored by the control circuit which adapts its output signal to the tunable thermal radiation source, for changing the amount of the emitted thermal radiation in relation to the monitored parameter value shift. This can be done by changing the intensity of the emitted thermal radiation, by switching the source on/off intermittently, or otherwise. The MEM resonating element absorbs the controlled thermal radiation emitted by the tunable thermal source, as a result of which the MEM element is brought to the operating temperature/point, at which the temperature dependent characteristic is at a desired, predetermined parameter value.

By providing thermal energy in the form of thermal radiation, the thermal energy can be focused towards the MEM resonating element thereby reducing or even avoiding directly heating the surroundings of the MEM resonating element. As the thermal energy can be more directly absorbed by the MEM resonating element, a much higher reaction speed of the device of the invention to temperature variations can be achieved compared to prior art devices.

In an embodiment, the MEM resonating element may be fabricated in a material having a low thermal conductivity (e.g. -10W/m/K or lower), such as for example silicon-germanium (SiGe). SiGe is a material having low thermal conductivity compared to e.g. Silicon, allowing the effective confinement of the absorbed thermal radiation to the resonator itself and reducing loss of thermal energy. This makes it possible to use higher operational temperatures (e.g. 75-85°C, for a thermal radiation of e.g. 50µW incident light power). The energy confinement may increase the range over which the temperature dependent parameter(s) of the MEM resonating element can be tuned as a function of the operating temperature, as a higher temperature increase equals a higher parameter shift.

In an embodiment, the MEM resonating element is suspended above a substrate by means of tethers having a high thermal resistance, (preferably at least an order higher than that of the MEM resonating element), i.e. preferably made of a material having low thermal conductivity (e.g. SiGe) and/or a small cross-sectional area (compared to that of the MEM resonating element) and/or a long length.

In an embodiment, the control circuit may further comprise a temperature sensor, placed in the proximity of the MEM resonating element, to measure the operating temperature of the MEM resonating element. The control circuit, in response to temperature data measured by the temperature sensor, may provide the control information using a mathematical relationship or data contained in a look-up table, to generate the appropriate output signal to a thermal radiation source. This adds a temperature compensation on top of the feedback loop which uses the temperature dependent parameter(s) of the MEM resonating element, by which accuracy can be enhanced.

In an embodiment, the control circuit comprises a comparator for comparing the measured value of the temperature dependent parameter, to a reference value thereof. From this comparison the relative shift of the effective parameter value towards the reference value can be determined. The reference value may be generated externally for example when the measured parameter is frequency. The reference may also be generated internally in the device. For example, when the measured parameter is a frequency, the device may comprise a second, calibrated resonator for providing a reference frequency, referred to as calibrated frequency, to the comparator of the control circuitry.

In an embodiment, the tunable thermal radiation source is a light source. This light source can be a LED, whose intensity can be adjusted by controlling the LED current supplied to the LED.

In an embodiment, the tunable thermal radiation source further comprises an optical waveguide for guiding the thermal radiation towards the MEM resonating element. The wavelength of the tunable thermal radiation source can be selected such that there is a maximum absorption of the thermal energy by the MEM resonating element. By selecting the wavelength for maximal absorption by the material(s) constituting the MEM resonating element, again absorption by other materials can be reduced thereby resulting in a more efficient use of the radiated thermal energy.

In an embodiment, the device is made of CMOS compatible materials. In particular the MEM resonating element may be fabricated in a material having a low thermal conductivity such as silicon-germanium (SiGe) and/or SiO2.

In an embodiment, the MEM resonating element is manufactured on a first substrate while the tunable thermal radiation source is manufactured on a second substrate, such as for example a capping wafer. This second substrate can be flip chipped onto the first substrate containing the MEM resonating element such that the thermal radiation source is facing the MEM resonating element. The stack of first and second substrates thereby forms a closed environment, i.e. a package, for the MEM resonating element and the thermal radiation source.

### Brief description of the drawings

The invention will be further elucidated by means of the following description and the appended figures.
Figure 1 shows a comparison of the resonance frequency drift of resonators composed of different materials.
Figure 2 shows an embodiment of a device according to the invention.
Figure 3 shows a schematic drawing of a bulk acoustic longitudinal resonator which can be used in embodiments of the invention.
Figure 4 shows measurement data for a 100x100 µm SiGe resonator showing the frequency change versus the incident light power on the resonator, according to an embodiment of the invention.
Figure 5 shows the resonator temperature vs. stabilization time illustrating the fast response time of a resonator element to incident light power, according to an embodiment of the invention.

### Modes for carrying out the invention

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequential or chronological order. The terms are interchangeable under appropriate circumstances and the embodiments of the invention can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the invention described herein can operate in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

As mentioned in the background section, several temperature compensation approaches are provided. In the following these are listed and compared.

***Voltage compensation**.* It is well established that, for electrostatically actuated resonators, applying a bias voltage over the actuation electrodes of a MEM resonator, introduces an electrostatic spring softening effect, causing a lowering of the resonance frequency with applied bias voltage. However for very stiff modes, e.g. high frequency bulk-acoustic longitudinal modes, the effect a bias voltage has on resonant frequency is very small. Rather high bias voltages (e.g., >50Vdc) are required to induce a noticeable frequency shift. Therefore, for these stiff modes, only a very small shift can be expected with respect to the applied voltage.

***Mechanical compensation**.* Heating up the resonator results in thermally-induced stresses and/or strains in the structural material. These stresses/strains may, depending on the design, lead to a shift of the resonant frequency. Therefore, this effect can be used as a compensation technique, i.e., the mechanical structure is designed in such a way that the thermal stresses/strains cause a frequency shift which is opposite to the frequency shift due to temperature variation. Typically however this requires quite specific designs that undesirably increase the complexity of the structure. Furthermore, a configuration as in W.-T., Hsu, J. R. Clark, et al., ., "Mechanically temperature-compensated flexural-mode micromechanical resonators", Technical Digest International Electron Devices Meeting 2000 (IEDM2000), pp. 399-402, employs unfocused or non-specific heating of the entire micromechanical resonator (uncertainty resonator is at same temperature).

Vis-à-vis these known techniques, the invention offers the following advantages. Devices according to the invention are insensitive to the stiffness of the resonator. The frequency shift due to temperature variations is a certain percentage of the resonance frequency; this percentage only depends on the material properties and is independent of stiffness or design of the resonator. It is noted though that the temperature increase with respect to the incident light power, is dependent on the design. Further, by providing thermal energy in the form of thermal radiation, the thermal energy can be focused towards the MEM resonating element thereby reducing or even avoiding directly heating the surroundings of the MEM resonating element. As the thermal energy can be more directly absorbed by the MEM resonating element, a much higher reaction speed of the device of the invention to temperature variations can be achieved compared to prior art devices.

In the example that follows, a bar resonator 20 is used as MEM resonating element. The invention is however not limited to resonant beams having rectangular cross sections. Further, the disclosure is directed to a temperature compensated micro-electromechanical resonator as well as controlling micro-electromechanical resonators having mechanical structures that include integrated heating and/or temperature sensing elements. The invention may further be applied in combination with the above mentioned techniques of voltage compensation and mechanical compensation, if desired.

There is a need for an efficient compensation technique for stability of MEM resonators, in particular the resonance frequency, over a temperature operating range, which compensation technique overcomes some or all of the shortcomings of the prior art resonators.

The proposed device for achieving higher temperature stability is shown schematically in figure 2 and comprises a resonator 20 connected to a control circuit 30 and a controlled thermal radiation source 40. In this device, changes in a temperature dependent parameter, e.g. the resonance frequency, are detected by the control circuit 30, which in its turn controls the thermal energy emitted by the thermal radiation source 40 (e.g. a light source such as an integrated LED). As can be seen in Figure 2, there is a feedback loop between the thermal radiation source 40, the resonator element 20 absorbing this thermal radiation, the control circuit 30 monitoring the temperature dependent parameter of this resonator element 20 and controlling the thermal radiation radiated by the thermal radiation source 40.

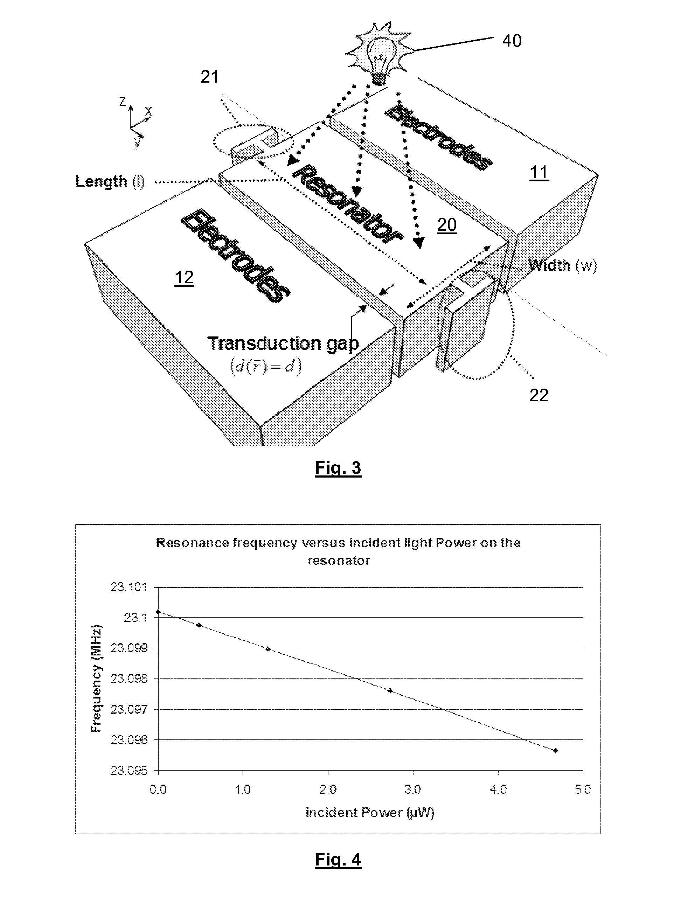

Figure 3 shows the bar resonator element more in detail. The bar resonator 20 is suspended between a pair of electrodes 11, 12. The first electrode 11 is used for applying a bias for causing the resonator element 20 to resonate at a predetermined frequency. The second electrode 12 is used for sensing the resonance frequency of the resonator element 20. Since the Young's modulus (E) of the resonating material is dependent on the temperature, a change in temperature of the resonator causes a change in the Young's modulus, which directly translates into a resonant frequency shift (as roughly speaking the resonant frequency is proportional to 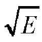 ).

In another embodiment, resistive sensing may be used, measuring changes in resistance with temperature. This can for example be done by supplying a current through the resonator or part thereof and measuring the voltage (or by putting a voltage over the resonator or part thereof and measuring the current). According to this measured voltage, which is indicative of resistance shift, the intensity of the thermal radiation source can be adapted via the control circuit. When thermal energy falls onto the resonator, it is absorbed by the material of the resonator and causes an increase of the temperature of the resonating element and the resistance changes. Since the electrical resistance (p) of the resonating material is dependent on the temperature, a change in temperature of the resonator causes a change in the resistance, which directly translate into a change of a current passing through the resonator.

The resonator 20 is preferably fabricated in a material having a low thermal conductivity, such as for example silicon-germanium (SiGe) based technology. SiGe is a material with low thermal conductivity, allowing focused absorption. This is an advantage over prior art thermal compensation techniques, wherein the heat source heats both resonator and its surroundings. For SiGe, preferably thermal radiation is used at a wavelength in the range from 500-1100 nm.

The heat is furthermore confined to the resonator 20 by suspending it by means of tethers 21, 22 having a high thermal resistance, i.e. made of a material having low thermal conductivity (e.g. SiGe) and/or a small cross-sectional area (compared to that of the MEM resonating element, e.g. 1 % or less) and/or a long length. In general, the smaller the cross sectional area of the tether and the longer the length of the tether, the better, but there is a tradeoff against the mechanical stability. One has some liberty in selecting the length, especially in the case of t-shaped tethers where one of the arms of the t-can be made relatively long while only minimally impacting the lateral mechanical stability. In the embodiment shown in figure 3, for example the following parameters can be used: resonator 20 tethers 21, 22 made of SiGe (thermal conductivity -10W/m/K); tether cross sectional area 1 x4µm2; tether length 13µm; MEM resonator cross sectional area 100x4µm²; MEM resonator length 100µm.

The device of figure 2 is operated as follows. The resonator 20 is first heated to an offset temperature T_{offset} with the thermal radiation source. Once T_{offset} has been reached, the control circuit is used to modulate the intensity of the thermal radiation source in response to changes in the resonance frequency, thereby influencing the temperature of the resonator 20 to be maintained at T_{offset}). An example of a control circuit could be a comparator, comparing the measured resonance frequency f₁ and a reference frequency source *f*₂ and giving an output signal proportional to the difference between the frequencies. Tuning the control circuit such that changes in the resonance frequency are compensated by changes in T_{offset} will achieve the desired frequency stabilization. Figure 4 shows the measured resonance frequency drift of a SiGe resonator in response to an external light source, such data could be used for tuning the control circuit to the desired accuracy.

The reference f₂ could be data stored in a digital lookup table or could be implemented by means of an analog circuit (since the temperature dependence is usually linear of the range of interest). The reference f₂ could also be an overtone of the resonator, as the absolute shift in frequency with temperature is higher for the overtone. In particular, one could calibrate for the difference between the frequency of interest and the overtone, and use the absolute shift as a metric for the temperature change.

In the alternative where electrical resistance is used as the temperature dependent parameter, the device is operated as follows, The resonator 20 is first heated to an offset temperature T_{offset} with the thermal radiation source. Once T_{offset} has been reached, the control circuit is used to modulate the intensity of the thermal radiation source (and therefore T_{offset}) in response to changes in the electrical resistance. An example of a control circuit could be a comparator, comparing the measured resistance value *R₁* and a reference resistance value R₂ and giving an output signal proportional to the difference between the resistance values. Tuning the control circuit such that changes in the resistance values are compensated by changes in T_{offset} will achieve the desired resistance stabilization.

The measured resistance value *R₁* and the reference resistance value *R*₂ can be AC, resp. DC voltages when an AC, resp. DC current source is used for sensing or AC, resp. DC currents when an AC, resp. DC voltage source is used for sensing. The currents/voltages may be continuous signals or intermitted signals.

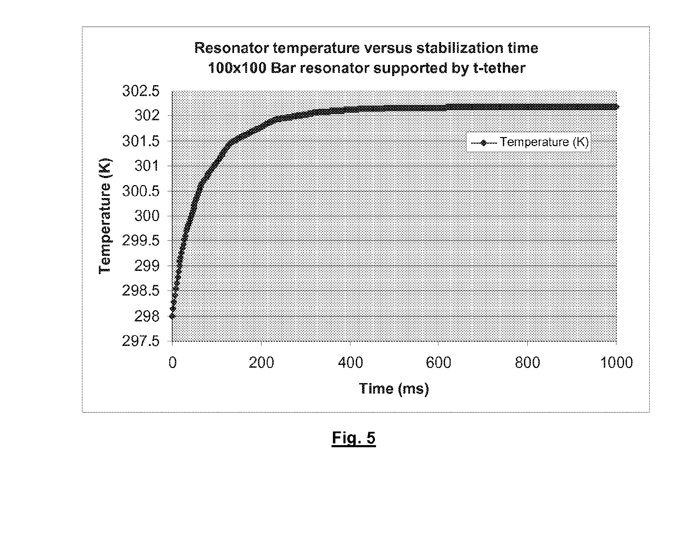

Figure 5 shows the resonator temperature vs. stabilization time illustrating the fast response time of a resonator element according to an embodiment of the invention. From this data one can conclude that this fast response time allows to swiftly correct shifts in the resonance frequency caused by absorbed thermal energy.

## Claims

1. A device comprising
a MEM resonating element (20), provided for resonating at a predetermined resonance frequency, the MEM resonating element having at least one temperature dependent characteristic;
a heating means (40), arranged for heating the MEM resonating element to an offset temperature (T_{offset});
a sensing means (11, 12), associated with the MEM resonating element and provided for sensing its temperature dependent characteristic;
a control circuit (30), connected to the sensing means (11, 12) for receiving measurement signals indicative of the sensed temperature dependent characteristic and connected to the heating means (40) for supplying a control signal (31) thereto, to maintain the temperature of the MEM resonating element (20) at the offset temperature;
**characterised in that** the heating means comprises a tunable thermal radiation source (40) and **in that** the MEM resonating element is provided for absorbing thermal radiation generated by the tunable thermal radiation source.

2. A device according to claim 1, **characterised in that** the MEM resonating element is in a material having a low thermal conductivity.

3. A device according to claim 1 or 2, **characterised in that** the MEM resonating element is in silicon-germanium.

4. A device according to any one of the previous claims, **characterised in that** the MEM resonating element is suspended above a substrate by means of tethers having a high thermal resistance.

5. A device according to any one of the previous claims, **characterized in that** the device comprises a temperature sensor, placed in proximity of the MEM resonating element, for measuring an operating temperature of the MEM resonating element and providing temperature data to the control circuit.

6. A device according to any one of the previous claims, **characterized in that** the control circuit comprises a comparator for comparing the measurement signals indicative of the sensed temperature dependent characteristic to a reference value thereof.

7. A device according to any one of the previous claims, **characterized in that** the tunable thermal radiation source is a LED, the control circuit being adapted for controlling a LED current supplied to the LED.

8. A device according to any one of the previous claims, **characterized in that** the tunable thermal radiation source further comprises an optical waveguide for guiding the thermal radiation towards the MEM resonating element.

9. A device according to any one of the previous claims, **characterized in that** the temperature dependent characteristic is the resonance frequency of the MEM resonating element.

10. A device according to any one of the previous claims, **characterized in that** the temperature dependent characteristic is the electrical resistance of the MEM resonating element.

11. A device according to any one of the previous claims, **characterized in that** the device is made of CMOS compatible materials.

12. A device according to any one of the previous claims, **characterized in that** the MEM resonating element is provided on a first substrate and the tunable thermal radiation source is provided on a second substrate, the second substrate being flip chipped onto the first substrate such that the thermal radiation source is facing the MEM resonating element and the stack of first and second substrates forms a closed environment for the MEM resonating element and the thermal radiation source.

13. A method for controlling a device comprising a MEM resonating element (20), provided for resonating at a predetermined resonance frequency and having at least one temperature dependent characteristic, the method comprising the steps of:
heating the MEM resonating element to an offset temperature (T_{offset}) by means of a heating means (40);
sensing the temperature dependent characteristic by means of sensing means (11, 12) associated with the MEM resonating element;
receiving measurement signals indicative of the sensed temperature dependent characteristic in a control circuit (30) and thereupon generating a control signal (31) for controlling the heating means (40) to maintain the temperature of the MEM resonating element (20) at the offset temperature;
**characterized in that** a tunable thermal radiation source (40) is used as the heating means and generates thermal radiation which is absorbed by the MEM resonating element.

14. A method according to claim 13, **characterized in that** the method further comprises the step of measuring an operating temperature of the MEM resonating element by means of a temperature sensor, placed in proximity of the MEM resonating element, and providing temperature data to the control circuit.

15. A method according to claim 13 or 14, **characterized in that** the method comprises the step of comparing the measurement signals indicative of the sensed temperature dependent characteristic to a reference value thereof, for generating the control signal.

16. A method according to any one of the claims 13-15, **characterized in that** the tunable thermal radiation source is a LED and that the step of controlling the heating means comprises controlling a LED current supplied to the LED.

17. A device according to any one of the claims 13-16, **characterized in that** the thermal radiation is guided towards the MEM resonating element by means of an optical waveguide.

18. A device according to any one of the previous claims, **characterized in that** the step of sensing the temperature dependent characteristic comprises measuring the resonance frequency of the MEM resonating element.

19. A device according to any one of the previous claims, **characterized in that** the step of sensing the temperature dependent characteristic comprises measuring the electrical resistance of the MEM resonating element.
